# EUROPEAN PATENT APPLICATION

(11) **EP 4 565 045 A2**
(43) Date of publication of application: **04.06.2025**
(21) Application number: 24210739.9
(22) Date of filing: 05.11.2024
(51) Int. Cl.: H10K 59/131, H10K 77/10

(54) **DISPLAY DEVICE AND THERMOSETTING CONDUCTIVE FILM**

(30) Priority: 29.11.2023 KR 20230169890
(71) Applicant: Samsung Display Co., Ltd., Yongin-si, Gyeonggi-Do 17113 (KR)
(72) Inventor: SUCHANG, Ryu, Giheung-Gu, Yongin-si, Gyeonggi-Do (KR); HYEONG-JUN, Kim, Giheung-Gu, Yongin-si, Gyeonggi-Do (KR); JUAN, Na, Giheung-Gu, Yongin-si, Gyeonggi-Do (KR); KI-SIK, Ban, Giheung-Gu, Yongin-si, Gyeonggi-Do (KR); SUKHO, Choi, Giheung-Gu, Yongin-si, Gyeonggi-Do (KR); JUNG KYU, Choi, Giheung-Gu, Yongin-si, Gyeonggi-Do (KR)
(74) Representative: Dr. Weitzel & Partner

(57) **Abstract**

A display device includes a display panel including a base layer, a driving element layer disposed on the base layer and including circuits, a light-emitting element layer disposed on the driving element layer and including a plurality of light-emitting elements respectively electrically connected to the circuits of the driving element layer, a plurality of pads disposed on the base layer, and a plurality of openings passing through the base layer, the driving element layer, and the plurality of pads, a circuit board disposed below the display panel, a plurality of conductive members disposed on the base layer and overlapping the plurality of pads, and a thermosetting member covering the plurality of conductive members, wherein the plurality of conductive members are respectively disposed in the plurality of openings and electrically connect the driving element layer and the circuit board.

## Description

### BACKGROUND

### 1. Technical Field

Embodiments relate to a display device and a thermosetting conductive film, and more particularly, to a display device having reduced area of a non-display region and capable of ensuring reliability of electrical connection, and to a thermosetting conductive film including aligned conductive members.

### 2. Description of the Related Art

A display device that provides an image to a user, such as a television, a monitor, a smartphone, and a tablet PC, includes a display panel for displaying an image. Various display panels such as liquid crystal display panels, organic light-emitting display panels, electrowetting display panels, and electrophoretic display panels have been developed.

Recently, in response to a market demand, research on reducing a region where an image is not displayed in a display panel has been conducted. Research on expanding a display region where an image is displayed to a user in a display panel has been conducted.

### SUMMARY

Embodiments provide a display device including a display panel having a reduced area of a non-display region.

Embodiments also provide a display device capable of improving reliability of electrical connection.

Embodiments also provide a thermosetting conductive film.

However, embodiments are not limited to those set forth herein. The above and other embodiments will become more apparent to one of ordinary skill in the art to which the invention pertains by referencing the detailed description of the invention given below.

The invention is defined by the independent claims. According to a first aspect, a display device includes a display panel including a base layer, a driving element layer disposed on the base layer and including circuits, a light-emitting element layer disposed on the driving element layer and including a plurality of light-emitting elements respectively electrically connected to the circuits of the driving element layer, a plurality of pads disposed on the base layer, and a plurality of openings passing through the base layer, the driving element layer, and the plurality of pads; a circuit board disposed below the display panel, a plurality of conductive members disposed on the base layer and overlapping the plurality of pads, and a thermosetting member covering the plurality of conductive members, wherein the plurality of conductive members may be respectively disposed in the openings and electrically connect the driving element layer and the circuit board.

In an embodiment, the plurality of conductive members may include a plurality of first-row conductive members arranged in a first direction, and a plurality of second-row conductive members spaced apart from the first-row conductive members in a second direction intersecting the first direction and arranged in the first direction.

In an embodiment, when viewed in the second direction, the plurality of second-row conductive members may not overlap the plurality of first-row conductive members.

In an embodiment, in plan view, sizes of the first-row conductive members and sizes of the second-row conductive members may be different from each other.

In an embodiment, the plurality of second-row conductive members may include a plurality of first conductive members and a plurality of second conductive members being aligned along the first direction, and the plurality of second conductive members may be disposed to be shifted in the second direction by a selected distance from the first conductive members.

In an embodiment, a cross-sectional area of each of the plurality of openings may decrease as being farther away from an upper surface of the base layer.

In an embodiment, in plan view, a width of each of the plurality of openings may be in a range of about 20 µm to about 40 µm.

In an embodiment, a maximum width of the plurality of conductive members may be substantially equal to or greater than a maximum width of the plurality of openings.

In an embodiment, sizes of upper surfaces of the plurality of conductive members may be substantially equal to or smaller than sizes of the plurality of pads.

In an embodiment, when viewed from above the base layer, the plurality of conductive members may be entirely covered by the thermosetting member.

In an embodiment, the display panel may further include an auxiliary pad disposed on an inner surface of at least one of the plurality of openings.

In an embodiment, when viewed from below the base layer, the plurality of conductive members may be entirely covered by the auxiliary pad.

In an embodiment, the plurality of conductive members may include tin (Sn), silver (Ag), or copper (Cu).

According to a second aspect, a thermosetting conductive film includes a base film including a lower surface defined by a first direction and a second direction intersecting each other and an upper surface opposed to the lower surface, a thermosetting film disposed on the lower surface of the base film, and a plurality of conductive members dispersed in the thermosetting film, passing through the thermosetting film in a cross-sectional view, and including tin (Sn).

In an embodiment, the plurality of conductive members may be arranged in the first direction, and a spacing between the plurality of conductive members adjacent to each other may be substantially equal to or greater than a width in the first direction of each of the plurality of conductive members.

In an embodiment, the base film may include silicon (Si).

In an embodiment, the thermosetting conductive film may further include a protective film disposed below the thermosetting film and covering the conductive member, and an adhesive film disposed between the thermosetting film and the protective film.

In an embodiment, diameters of the plurality of conductive members may be in a range of about 30 µm to about 130 µm.

In an embodiment, the plurality of conductive members may have an initial form of a sphere.

In an embodiment, widths of the plurality of conductive members in the first direction or the second direction may decrease as being farther away from the thermosetting film.

All embodiments may have an advantage of aligning a thermosetting substrate on which a plurality of solder balls is mounted to the holes and then soldering multiple holes at the same time. This may have the effect of soldering thousands of solder holes simultaneously. Further, soldering may be possible with heat and pressure, therefore a soldering process may be possible in holes with a small size, in particular tens to several microns. Because pressure is applied, smooth soldering may be possible even in holes with a deep depth to width ratio.

### BRIEF DESCRIPTION OF THE DRAWINGS

The accompanying drawings are included to provide a further understanding of the invention, and are incorporated in and constitute a part of this specification. The drawings illustrate embodiments and, together with the description, serve to explain principles of the invention. In the drawings:
FIG. 1 is a schematic perspective view of an electronic device according to an embodiment;
FIG. 2 is an exploded schematic perspective view of a display device according to an embodiment;
FIG. 3 is a schematic plan view of a display panel according to an embodiment;
FIG. 4 is a schematic cross-sectional view of a display module according to an embodiment;
FIGS. 5A and 5B are schematic cross-sectional views of a display device according to an embodiment;
FIG. 6A is an enlarged schematic view of a portion of a display module according to an embodiment;
FIG. 6B is a schematic plan view of a display module according to an embodiment;
FIG. 6C is an enlarged schematic view of a portion of a display module according to an embodiment;
FIG. 7 is a schematic cross-sectional view of a thermosetting conductive film according to an embodiment;
FIGS. 8A to 8C are schematic plan views of a thermosetting conductive film according to an embodiment;
FIGS. 9A to 9C are schematic cross-sectional views of a thermosetting conductive film according to an embodiment; and
FIGS. 10A to 10D are schematic cross-sectional views illustrating some of operations of coupling a thermosetting conductive film to a display panel.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this invention, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, a display panel and a method of manufacturing the same according to an embodiment will be described with reference to the accompanying drawings.

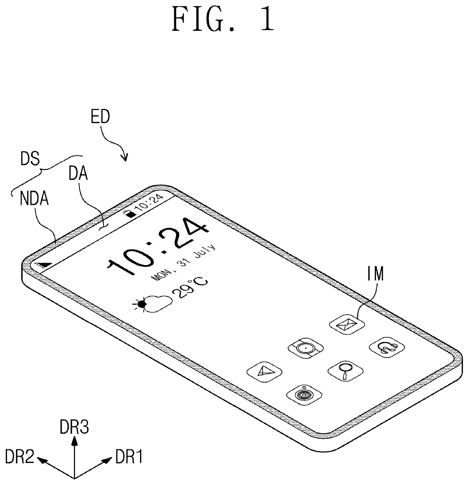

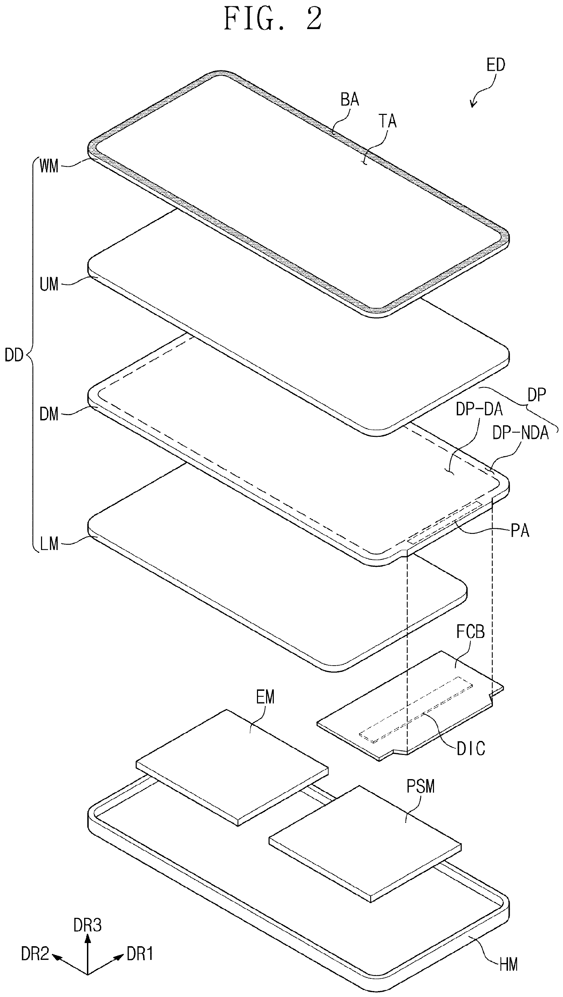

FIG. 1 is a schematic perspective view of an electronic device according to an embodiment. FIG. 2 is an exploded schematic perspective view of an electronic device according to an embodiment.

Referring to FIG. 1, an electronic device ED according to an embodiment may include a display surface DS, which is defined by a first direction DR1 and a second direction DR2 intersecting each other. The electronic device ED may provide an image IM to a user through the display surface DS.

The display surface DS may include a display region DA and a non-display region NDA around the display region DA. The display region DA may display the image IM, and the non-display region NDA may not display the image IM. The non-display region NDA may surround the display region DA. However, embodiments are not limited thereto, and shapes of the display region DA and the non-display region NDA may be modified.

Hereinafter, a direction, which is substantially perpendicular to a plane defined by the first direction DR1 and the second direction DR2, is defined as a third direction DR3. A front surface and a rear surface of each member are distinguished on the basis of the third direction DR3. As used herein, the wording "in plan view" may be defined as a state of being viewed in the third direction DR3. Hereinafter, the first to third directions DR1, DR2, and DR3 are respective directions indicated by first to third direction axes and denoted as the same reference numerals or symbols as those of the direction axes.

In an embodiment, the electronic device ED may also be a foldable electronic device that is foldable with respect to a folding axis. The folding axis may be parallel to the first direction DR1 or the second direction DR2, and a folding region may be defined in a portion of the display region DA. The electronic device ED may be in-folded so that portions of the display region DA may face each other, or the electronic device ED may be out-folded so that portions of the display region DA may face away from each other.

As illustrated in FIG. 2, an electronic device ED may include a display device DD, an electronic module EM, a power module PSM, and a housing HM. FIG. 2 schematically illustrates the electronic device ED. For example, the electronic device ED may further include a mechanical structure (e.g., a hinge) for controlling an operation (e.g., folding or rolling) of the display device DD.

The display device DD may generate an image and senses an external input. The display device DD includes a window WM, an upper member UM, a display module DM, a lower member LM, a circuit board FCB, and a driving chip DIC. The upper member UM may include members disposed above the display module DM, and the lower member LM may include members disposed below the display module DM.

The window WM may provide a front surface of the electronic device ED. The window WM may include a transmission region TA and a bezel region BA. The display region DA and the non-display region NDA of the display surface DS illustrated in FIG. 1 are defined by the transmission region TA and the bezel region BA. The transmission region TA may be a region which an image passes, and the bezel region BA may be a region which covers a structure/member disposed below the window WM.

The display module DM may include at least a display panel DP. FIG. 2 illustrates only the display panel DP among a stacked structure of the display module DM, but the display module DM may substantially further include an additional component disposed on the display panel DP as well as the display panel DP. Detailed description of a stacked structure of the display module DM will be made later.

The display panel DP is not limited thereto, and may include, for example, an organic light-emitting display panel or an inorganic light-emitting display panel. The display panel DP may include a display region DP-DA and a non-display region DP-NDA corresponding to the display region DA and the non-display region NDA illustrated in FIG. 1. As used herein, the wording "a region/portion corresponds to a region/portion" means that the region/portion overlaps the region/portion and is not limited to a case in which the regions/portions have the same area.

A pad region PA of the display panel DP may be disposed in a side of the non-display region DP-NDA. The pad region PA may be a region which is electrically bonded (or connected) to the circuit board FCB to be described later. In an embodiment, the pad region PA may be defined on a rear surface of the display panel DP.

The display panel DP may substantially have a quadrangular shape in plan view. Here, "substantially quadrangular shape" includes not only a quadrangular shape in a mathematical sense but also a shape similar to a quadrangle which may be perceived as a quadrangle by a user. For example, the substantially quadrangular shape may include a quadrangular shape having a rounded corner region. For example, the substantially quadrangular shape may not be limited to a shape of the display panel DP having a straight edge portion, and the edge portion may include a curved region.

The upper member UM may include a protective film or an optical film. The optical film may include a polarizer and a retarder for reducing external light reflection. The lower member LM may include a protective film for protecting the display panel DP, a supporting member for supporting the display panel DP, a digitizer, etc. Detailed description of the upper member UM and the lower member LM will be made later.

The circuit board FCB illustrated in FIG. 2 may be disposed below the display panel DP. The circuit board FCB may be bonded to the rear surface of the display panel DP, and may electrically connect the display panel DP and a main circuit board. The circuit board FCB may include at least one insulating layer and at least one conductive layer. The conductive layer may include signal lines.

The driving chip DIC may be mounted on the circuit board FCB. The driving chip DIC may include a driving circuit, for example, a data driving circuit, for driving a pixel of the display panel DP. FIG. 2 illustrates a structure in which the driving chip DIC is mounted on the circuit board FCB, but embodiments are not limited thereto. For example, the driving chip DIC may also be mounted on the display panel DP or a main circuit board.

The electronic module EM may include elements such as a control module, a wireless communication module, an image input module, a sound input module, a sound output module, a memory, an external interface module, and the like. The electronic module EM may include a main circuit board, and the elements of the electronic module EM may be mounted on the main circuit board or electrically connected to the main circuit board through a flexible circuit board. The electronic module EM may be electrically connected to the power module PSM.

For example, the electronic device ED may further include an electro-optical module. The electro-optical module may be an electronic component for outputting or receiving an optical signal. The electro-optical module may include a camera module and/or a proximity sensor. The camera module may capture an external image through a partial region of the display panel DP.

The housing HM illustrated in FIG. 2 may be coupled to the display device DD (e.g., the window WM), and accommodates the other modules. The housing HM is illustrated as having an integral shape, but embodiments are not limited thereto. The housing HM may include portions (e.g., a side edge portion and a bottom portion) that are coupled to each other.

The upper member UM may include a synthetic resin film. The synthetic resin film may include polyimide, polycarbonate, polyamide, triacetylcellulose, or polymethylmethacrylate, or polyethylene terephthalate.

The upper member UM may absorb an external impact applied to a front surface of the display device DD. In an embodiment, the display module DM may include a color filter which replaces a polarizing film as an anti-reflective member, thereby reducing impact strength of the front surface of the display device DD. The upper member UM may compensate for the impact strength which is reduced due to application of the color filter.

The synthetic resin film overlaps the bezel region BA and the transmission region TA. The synthetic resin film may overlap only a partial region of the bezel region BA. In another example, the synthetic resin film may also be omitted. In another example, the synthetic resin film may be replaced by an optical film including a polarizer and a retarder.

The upper member UM may further include a first adhesive layer which bonds the synthetic resin film and the window WM, and a second adhesive layer which bonds the synthetic resin film and the display module DM. The first adhesive layer and the second adhesive layer may each be a pressure sensitive adhesive (PSA) film or an optically clear adhesive (OCA) member. Adhesive layers to be described below may also include the same adhesive as that of the first adhesive layer.

The display module DM may be disposed below an synthetic resin film. The display module DM overlaps the bezel region BA and the transmission region TA. The display module DM may overlap (e.g., entirely overlap) the upper film in the bezel region BA. A side surface of the display module DM may be aligned with a side surface of the upper film, and in plan view, a corner portion of the display module DM may be aligned with a corner portion of the upper film.

The pad region PA may overlap the synthetic resin film in the bezel region BA. A portion of the display module DM corresponding to the pad region PA may be bonded to a lower surface of the upper film by the second adhesive layer. Since the pad region PA may overlap the upper film, and a portion of the display module DM overlapping the pad region PA may be bonded to the upper film, the upper film may sufficiently support the pad region PAin case that the circuit board FCB is bonded to the pad region PA.

The lower member LM may include a lower film and a cover panel. In an embodiment, the lower member LM may further include a supporting plate and a digitizer. Description thereof will be made later.

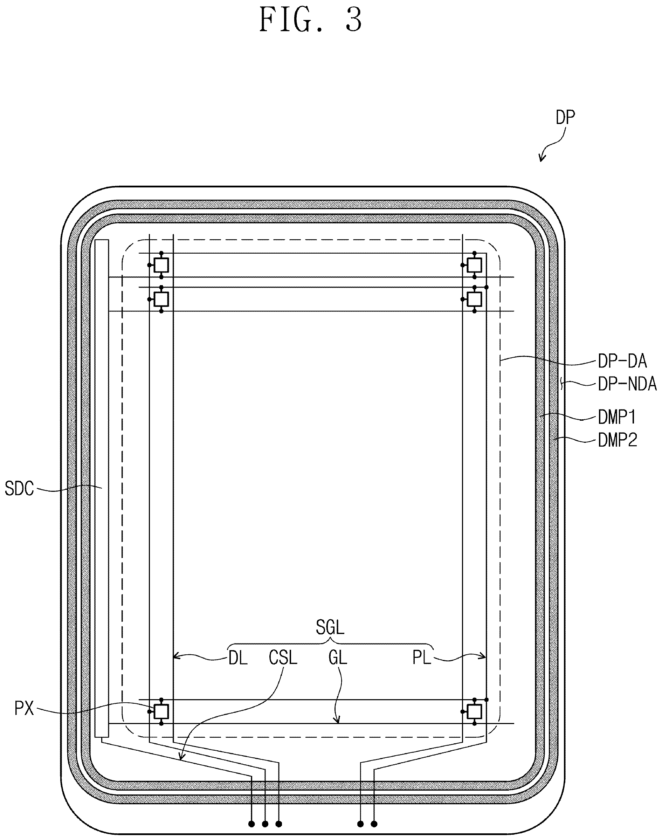

FIG. 3 is a schematic plan view of a display panel DP according to an embodiment.

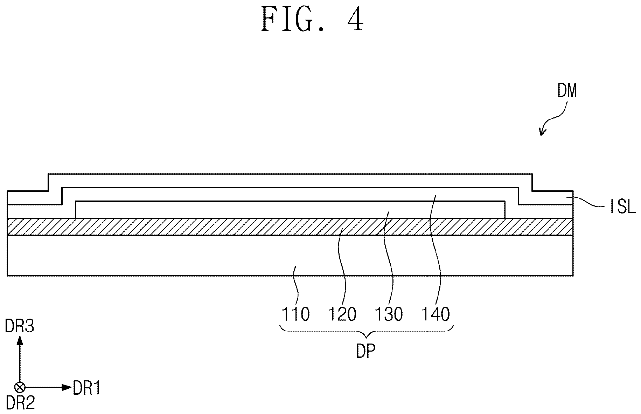

As illustrated in FIG. 3, the display panel DP may include a scan driving circuit SDC, signal lines SGL, and pixels PX. The pixels PX may be disposed in a display region DP-DA. Each of the pixels PX may include a light-emitting element and a pixel driving circuit connected to the light-emitting element. The scan driving circuit SDC, the signal lines SGL, and the pixel driving circuit may be included in a driving element layer 120 illustrated in FIG. 4 to be described later.

The scan driving circuit SDC may include a gate driving circuit. The gate driving circuit may generate scan signals and may sequentially output the scan signals to scan lines GL to be described later. The scan driving circuit SDC may further include an emission driving circuit which is separated from the gate driving circuit. The emission driving circuit may output scan signals to another group of scan lines.

The scan driving circuit SDC may include thin-film transistors which are formed by the same process, for example, a low temperature polycrystalline silicon (LTPS) process or a low temperature polycrystalline oxide (LTPO) process, as that for the pixel driving circuit.

The signal lines SGL may include the scan lines GL, data lines DL, a power line PL, and a control signal line CSL. Each of the scan lines GL may be connected to corresponding pixel PX among the pixels PX, and each of the data lines DL may be connected to corresponding pixel PX among the pixels PX. The power line PL may be connected to the pixels PX. The data lines DL may provide data signals to the pixels PX. The control signal line CSL may provide control signals to the scan driving circuit SDC.

The power line PL may include a first power line which receives a first power voltage and a second power line which receives a second power voltage having a higher level than the first power voltage. The first power voltage may be provided to the pixels PX through the first power line, and the second power voltage may be provided to the pixels PX through the second power line. A single control signal line CSL is illustrated as an example, but the control signal line CSL may be provided in plurality.

The scan lines GL, the data lines DL, and the power line PL may overlap the display region DP-DA and a non-display region DP-NDA, and the control signal line CSL may overlap the non-display region DP-NDA. End portions of the signal lines SGL may be aligned at a side of the non-display region DP-NDA. Each of the signal lines SGL may have an integral shape, but may include different portions disposed on different layers. The different portions which are separated from each other by an insulating layer may be connected to each other through a contact hole passing through the insulating layer. For example, the data lines DL may include a first portion disposed in the display region DP-DA and a second portion disposed in the non-display region DP-NDA and disposed on a layer different from a layer on which the first portion is disposed. The first portion and the second portion may include different materials and have different stacked structures.

The display panel DP may include insulating patterns DMP1 and DMP2. FIG. 3 illustrates first and second insulating patterns DMP1 and DMP2. The first and second insulating patterns DMP1 and DMP2 may be disposed in the non-display region DP-NDA and surround the display region DP-DA. Each of the first and second insulating patterns DMP1 and DMP2 may have a closed-line shape. The first and second insulating patterns DMP1 and DMP2 may function as a dam for preventing a liquid organic material from overflowing in an inkjet process for the display panel DP. Detailed description thereof will be made later.

FIG. 4 is a schematic cross-sectional view of a display module DM according to an embodiment.

Referring to FIG. 4, the display module DM may include a display panel DP and an input sensor ISL. The display panel DP may include a base layer 110, a driving element layer 120, a light-emitting element layer 130, and an encapsulation layer 140.

The driving element layer 120 may be disposed on an upper surface of the base layer 110. The base layer 110 may be a flexible substrate that is bendable, foldable, rollable, etc. The base layer 110 may be a glass substrate, a metal substrate, a polymer substrate, or the like. However, embodiments are not limited thereto, and the base layer 110 may be an inorganic layer, an organic layer, or a composite material layer. The base layer 110 may substantially have the same shape as that of the display panel DP.

The base layer 110 may have a multi-layered structure. For example, the base layer 110 may include a first synthetic resin layer, a second synthetic resin layer, and inorganic layers disposed therebetween. Each of the first and second synthetic resin layers may include a polyimide-based resin, but embodiments are not limited thereto.

The driving element layer 120 may be disposed on the base layer 110. The driving element layer 120 may include insulating layers, semiconductor patterns, conductive patterns, signal lines, and the like. The driving element layer 120 may include a pixel driving circuit. Hereinafter, unless otherwise specified, it is interpreted that if a component A and a component B is disposed on the same layer, the components are formed by the same process and include the same material or have the same stacked structure. Conductive patterns or semiconductor patterns disposed on the same layer may be interpreted as what is described above.

The light-emitting element layer 130 may be disposed on the driving element layer 120. The light-emitting element layer 130 may include a light-emitting element. For example, the light-emitting element may include an organic light-emitting material, an inorganic light-emitting material, an organic-inorganic light-emitting material, a quantum dot, a quantum rod, a micro-LED, or a nano-LED. The light-emitting element layer 130 may have a smaller size than the driving element layer and/or the base layer 110.

The encapsulation layer 140 may be disposed on the light-emitting element layer 130. The encapsulation layer 140 may protect the light-emitting element layer 130, e.g., the light-emitting element, from moisture, oxygen, and foreign substances such as dust particles. The encapsulation layer 140 may may have a greater size than the light-emitting element layer 130. The encapsulation layer 140 may overlap the light-emitting element layer 130The encapsulation layer 140 may include at least one inorganic encapsulation layer. The encapsulation layer 140 may include a stacked structure, which is formed by sequentially stacking a first inorganic encapsulation layer, an organic encapsulation layer, and a second inorganic encapsulation layer.

The input sensor ISL may be disposed (e.g., directly disposed) on the display panel DP. The input sensor ISL may sense a user's input by, for example, an electromagnetic induction method or a capacitive method. The display panel DP and the input sensor ISL may be formed by a continuous process. Here, being "directly disposed" may mean that there is no intervening element disposed between the input sensor ISL and the display panel DP. For example, there may be no separate adhesive layer disposed between the input sensor ISL and the display panel DP.

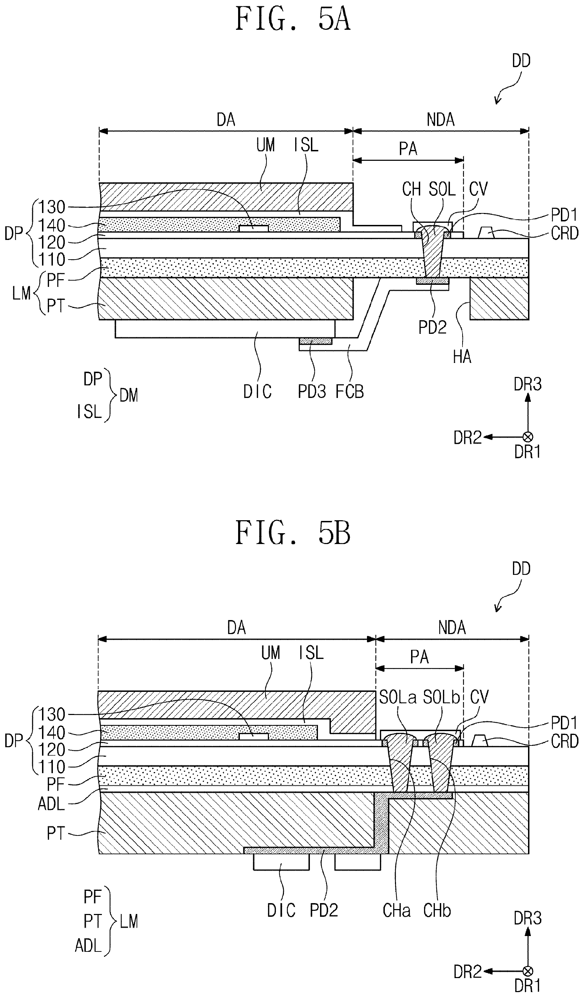

FIGS. 5A and 5B are schematic cross-sectional views of a display device according to an embodiment.

Fig. 5A provides an embodiment of the invention, showing a part of a display device DD. Referring to FIGS. 5A and 5B, a display device DD may include a display panel DP, a circuit board FCB, a driving chip DIC, an upper member UM, and a lower member LM.

An opening CH may be defined (or formed) in the display panel DP. For example, the opening CH may be defined by passing through a base layer 110 and a driving element layer 120. The opening CH may be provided in plurality.

First pads PD1 may be disposed on the base layer 110 of the display panel DP. For example, the first pads PD1 may be disposed on an upper portion of the base layer 110. The first pads PD1 may overlap at least one opening CH.

The circuit board FCB may be disposed below the display panel DP. The circuit board FCB may include second pads PD2 and third pads PD3. Each of the second pads PD2 and the third pads PD3 may be disposed on a portion of the circuit board FCB. The second pads PD2 and the third pads PD3 may be positioned on a lower portion of the display panel DP.

The second pads PD2 of the circuit board FCB may be electrically connected to the first pads PD1 through a conductive member SOL to be described later. The first pads PD1 may overlap the second pads PD2 in plan view.

The driving chip DIC may be disposed below the display panel DP. The driving chip DIC may be connected to the third pads PD3 of the circuit board FCB.

The conductive member SOL may be disposed on the base layer 110. For example, the conductive member SOL may be accommodated (or filled) in the opening CH. The conductive member SOL may be accommodated (or filled) in the opening CH and electrically connect the first pad PD1 and the second pad PD2.

The conductive member SOL may be provided in plurality. Conductive members SOL may be respectively accommodated (or filled) in openings CH and respectively electrically connect the first pads PD1 and the second pads PD2. The openings CH and the conductive members SOL may have a conical shape. In particular, the opening CH may have a bigger diameter in the driving element layer 120 than in the base layer 110.

Th openings CH may also be provided in the first pads PD1. Thus, the conductive members SOL may be provided in the opening CH of the first pads PD1.

The conductive members SOL may overlap the first pads PD1 in plan view. In other words, the conductive members SOL may contact an upper surface of the first pads PD1. Also, the conductive members SOL may overlap the second pads PD2. In other words, the conductive members SOL may contact an upper surface of the second pads PD2. IN particular, the second pads PD2 are located below the first pads PD1 with the conductive members SOL therebetween.

The conductive member SOL may include a conductive material. For example, the conductive material may include tin (Sn), silver (Ag), or copper (Cu), but embodiments are not limited thereto.

A thermosetting member CV may cover the conductive members SOL. The thermosetting member CV may protect the conductive members SOL from external damage. The thermosetting member CV may protect the conductive members SOL from an external foreign substance (e.g., moisture, etc.) and prevent the external foreign substance from being introduced (or permeated) into the openings CH.

The thermosetting member CV may overlap a non-display region NDA. The thermosetting member CV may overlap a pad region PA. The thermosetting member CV may be spaced apart from a display region DA.

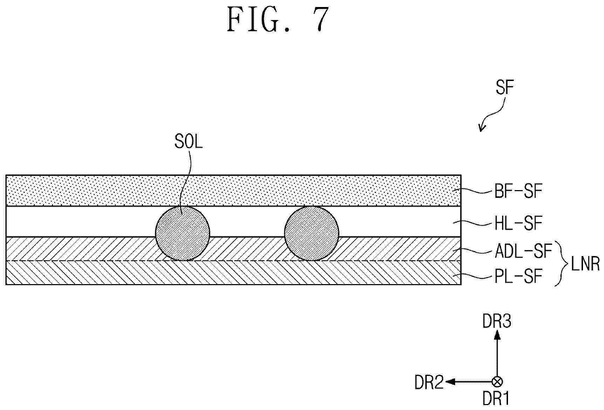

Fig. 7 provides a further embodiment of the invention showing a base film BF-SF. The base film BF-SF may be further disposed on the thermosetting member CV, wherein the thermosetting member CV may be the thermosetting member CV as shown in the figs. 5A to 6C. Along with the thermosetting member CV, the base film BF-SF (see FIG. 7) may protect the conductive members SOL and the openings CH from the external foreign substance. The thermosetting member CV may be a thermosetting film HL-SF (see FIG. 7) that is thermally cured by being pressed and heated after a thermosetting film HL-SF (see FIG. 7) of a thermosetting conductive film SF (see FIG. 7) is disposed on a base layer 110.

The lower member LM may include a lower film PF and a supporting plate PT.

The lower film PF may be disposed below a display module DM and bonded to a lower surface of the display module DM by a third adhesive layer. The lower film PF may protect a lower portion of the display module DM. The lower film PF may include a flexible synthetic resin film. For example, the lower film PF may include polyethylene terephthalate or polyimide, but embodiments are not limited thereto.

The lower film PF may improve resistance to compressive force caused by external pressing. Thus, the lower film PF may function as protecting the display panel DP from deformation. The lower film PF may include a flexible plastic material such as polyimide or polyethylene terephthalate. For example, the lower film PF may be a colored film having a low light transmittance. The lower film PF may absorb light incident from the outside. For example, the lower film PF may be a black synthetic resin film. In case that the display device DD is viewed from above a window WM, components disposed under the lower film PF may not be visible to a user.

The supporting plate PT may also be further disposed under the lower film PF. The supporting plate PT may include a metal material having high strength. The supporting plate PT may also include a fiber-reinforced composite material. The supporting plate PT may include a reinforced fiber disposed inside a matrix part. The reinforced fiber may be a carbon fiber or a glass fiber. The matrix part may include a polymer resin. The matrix part may include a thermoplastic resin. For example, the matrix part may include a polyamide-based resin or a polypropylene-based resin. For example, the fiber-reinforced composite material may be carbon fiber reinforced plastic (CFRP) or glass fiber reinforced plastic (GFRP).

Referring to FIG. 5A, a plate opening HA may be defined (or formed) in the supporting plate PT. A portion of the supporting plate may be removed in the plate opening HA. The plate opening HA may overlap the non-display region NDA and the pad region PA. However, embodiments are not limited thereto, and the plate opening HA may overlap the display region DA.

A portion of the circuit board FCB may be accommodated in the plate opening HA. The second pad PD2 may be accommodated in the plate opening HA. In plan view, the plate opening HA may overlap the first pad PD1, the second pad PD2, and the conductive member SOL.

A crack dam CRD may be disposed on the base layer 110. The crack dam CRD may be disposed in the non-display region NDA. The crack dam CRD may be spaced apart from a driving element layer 120. Also, the crack dam CRD may be spaced apart from the thermosetting member CV.

In case that an external impact is applied to an edge portion of the display module DM, the crack dam CRD may break and absorb the impact. As the crack dam CRD breaks, a crack may be stopped and prevented from expanding to the pad region PA and the display region DA.

The crack dam CRD may include a stacked structure corresponding to a stacked structure of an insulating layer of the driving element layer 120. The drawing illustrates a single crack dam CRD, but the crack dam CRD may be provided in plurality.

Referring to FIG. 5B, a plate opening HA may not be defined (or formed) in a supporting plate PT. For example, a second pad PD2 may be provided in the supporting plate PT, and the second pad PD2 may be electrically connected to a conductive member SOL and a first pad PD1 in the supporting plate PT. For example, the lower film PF may be attached to the supporting plate PT by an adhesive layer ADL.

For example, conductive members SOLa and SOLb may be respectively accommodated (or filled) in openings CHa and CHb.

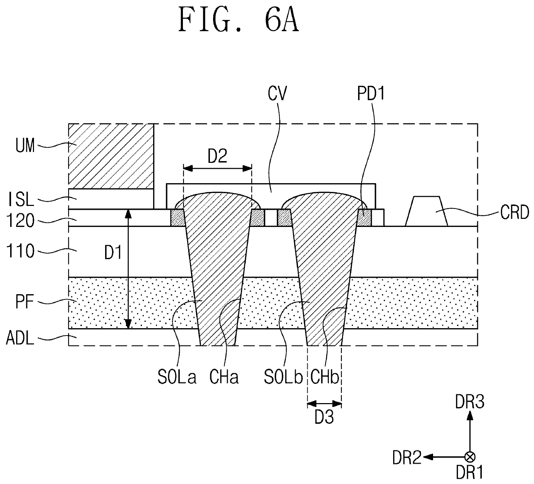

FIG. 6A is an enlarged schematic view of a portion of a display module DM according to an embodiment. FIG. 6A is an enlarged schematic view of a portion of the display device DD according to an embodiment in FIG. 5B. Description to be made later with reference to FIG. 6A may also be applied to the display device DD according to an embodiment in FIG. 5A.

Referring to FIG. 6A, a height (or a depth) D1 of the openings CHa and CHb may be greater than a diameter (D2 or D3) of the openings CHa and CHb.

For example, in a thickness direction of a display panel DP (see FIG. 5B), the height D1 of the openings CHa and CHb may be in a range of about 100 µm or more. For example, the height D1 of the openings CHa and CHb in a third direction DR3 may be in a range of about 100 µm or more.

A cross-sectional diameter of the openings CHa and CHb may be in a range of about 20 µm to about 40 µm. A cross-sectional area of the openings CHa and CHb may decrease as being farther away from an upper surface of a base layer 110.

A first diameter D2 of the openings CHa and CHb in the upper surface of the base layer 110 may be in a range of about 30 µm to about 40 µm. A second diameter D3 of the openings CHa and CHb at a lower surface of the base layer 110 may be in a range of about 20 µm to about 30 µm. For example, a maximum diameter of the openings CHa and CHb may be in a range of about 40 µm.

Referring to the drawing, a maximum width of the conductive members SOLa and SOLb may be substantially equal to or greater than a maximum width of the openings CHa and CHb. A maximum diameter of the conductive members SOLa and SOLb may be substantially equal to or greater than the maximum diameter of the openings CHa and CHb.

The conductive members SOLa and SOLb may have the maximum width that is substantially equal to or greater than the maximum width of the openings CHa and CHb, thereby preventing an external foreign substance from being introduced (or permeated) into the openings CHa and CHb. For example, the first pad PD1 and the second pad PD2 (see FIG. 5A) may be electrically connected through the conductive members SOLa and SOLb which is accommodated (or filled) in the openings CHa and CHb, thereby improving reliability of electrical connection between the first pad PD1 and the second pad PD2.

As will be described later, a diameter of a conductive member SOL (see FIG. 7) of a thermosetting conductive film SF (see FIG. 7) may be in a range of about 30 µm to about 130 µm. In case that the display panel DP (see FIG. 5B) in which the openings CHa and CHb having the height D1 range and the diameter range described above is defined and the thermosetting conductive film SF (see FIG. 7) including the conductive member SOL (see FIG. 7) having the diameter range described above is coupled to each other, the conductive member SOL (see FIG. 7) may be readily accommodated (or filled) in the openings CHa and CHb, and through the conductive members SOLa and SOLb, reliability of electrical connection between the display panel DP (see FIG. 5B) and a circuit board FCB (see FIG. 2) may be improved or ensured.

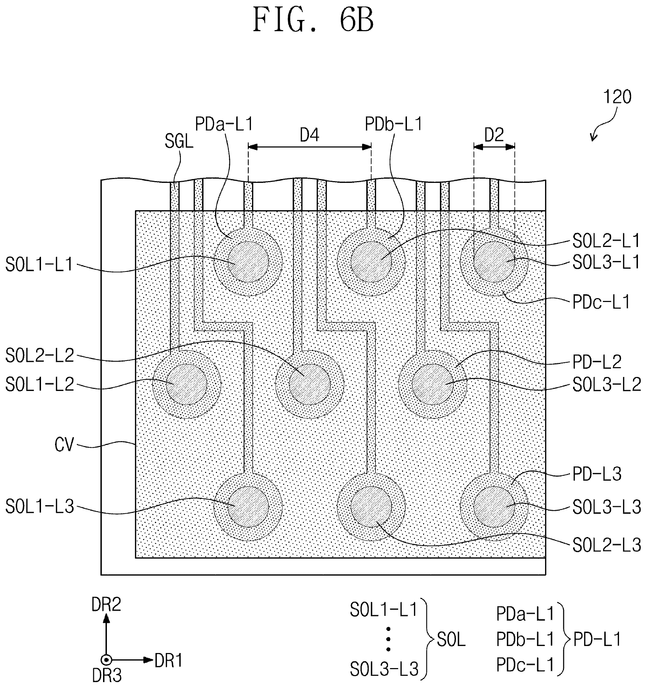

FIG. 6B is a schematic plan view of a portion of a display module DM according to an embodiment.

Referring to FIG. 6B, first pads PD1 (see FIG. 6A) may include first-row pads PD-L1, second-row pads PD-L2, and third-row pads PD-L3.

The first-row pads PD-L1 and the second-row pads PD-L2 may be spaced apart from each other in a second direction DR2. The second-row pads PD-L2 and the third-row pads PD-L3 may be spaced apart from each other in the second direction DR2.

The first-row pads PD-L1 may be arranged in a first direction DR1. For example, the first-row pads PD-L1 may include a first-first row pad PDa-L1, a second-first row pad PDb-L1, and a third-first row pad PDc-L1. The first-first row pad PDa-L1, the second-first row pad PDb-L1, and the third-first row pad PDc-L1 may be sequentially arranged in the first direction DR1. A distance between center portions of adjacent first-row pads PD-L1 among the first-row pads PD-L1 may be a fourth distance D4. In case that the first diameter D2 (see FIG. 6A) of the openings CHa and CHb (see FIG. 6A) described above is about 40 µm, the fourth distance D4 may be in a range of about 80 µm or more. In another example, the fourth distance D4 may be in a range of about 85 µm to about 90 µm.

The second-row pads PD-L2 may be arranged in the first direction DR1. The second-row pads PD-L2 may be shifted in the first direction DR1 by a selected distance from the first-row pads PD-L1.

The third-row pads PD-L3 may be arranged in the first direction DR1. The third-row pads PD-L3 may be shifted in the first direction DR1 by a selected distance from the second-row pads PD-L2.

Signal lines SGL may be respectively connected to the first to third-row pads PD-L1, PD-L2, and PD-L3 arranged in the first direction DR1 and the second direction DR2. The fourth distance D4 may be in a range of about 80 µm or more, and signal lines SGL respectively connected to the second-row pad PD-L2 and the third-row pad PD-L3 may pass between adjacent first-row pads PD-L1.

In plan view, the first to third-row pads PD-L1, PD-L2, and PD-L3 may be respectively adjacent to the openings CHa and CHb (see FIG. 6A) and surround the openings CHa and CHb (see FIG. 6A). In another example, the openings CHa and CHb (see FIG. 6A) may overlap the first to third-row pads PD-L1, PD-L2, and PD-L3.

An arrangement relationship of the openings CHa and CHb (see FIG. 6A) may correspond to an arrangement relationship of the first to third-row pads PD-L1, PD-L2, and PD-L3.

Conductive members SOL may include first-row conductive members SOL1-L1, SOL2-L1, and SOL3-L1, second-row conductive members SOL1-L2, SOL2-L2, and SOL3-L2, and third-row conductive members SOL1-L3, SOL2-L3, and SOL3-L3. The first-row conductive members SOL1-L1, SOL2-L1, and SOL3-L1, second-row conductive members SOL1-L2, SOL2-L2, and SOL3-L2, and third-row conductive members SOL1-L3, SOL2-L3, and SOL3-L3 may each have a round shape, see fig. 6B.

The first-row conductive members SOL1-L1, SOL2-L1, and SOL3-L1 and the second-row conductive members SOL1-L2, SOL2-L2, and SOL3-L2 may be spaced apart from each other in the second direction DR2. The second-row conductive members SOL1-L2, SOL2-L2, and SOL3-L2 and the third-row conductive members SOL1-L3, SOL2-L3, and SOL3-L3 may be spaced apart from each other in the second direction DR2.

The first-row conductive members SOL1-L1, SOL2-L1, and SOL3-L1 may be arranged in the first direction DR1. The second-row conductive members SOL1-L2, SOL2-L2, and SOL3-L2 may be arranged in the first direction DR1. The third-row conductive members SOL1-L3, SOL2-L3, and SOL3-L3 may be arranged in the first direction DR1.

In plan view, the first to third-row pads PD-L1, PD-L2, and PD-L3 may respectively overlap conductive members SOL, and an arrangement relationship of the conductive members SOL may correspond to the arrangement relationship of the first to third-row pads PD-L1, PD-L2, and PD-L3.

The drawing illustrates only the first to third-row pads PD-L1, PD-L2, and PD-L3 and the first to third-row conductive members SOL, but a display device may further include fourth-row pads and fourth-row conductive members.

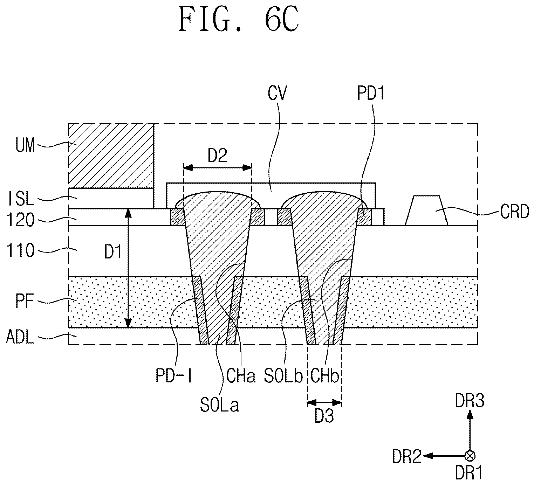

FIG. 6C is an enlarged schematic view of a portion of a display module DM according to an embodiment.

Referring to FIG. 6C, the display panel DP (see FIG. 5B) may further include an auxiliary pad PD-I. The auxiliary pad PD-I may be disposed on an inner surface of openings CHa and CHb. Referring to the drawing, the auxiliary pad PD-I may cover a portion of the inner surface of the openings CHa and CHb. However, embodiments are not limited thereto, and the auxiliary pad PD-I may entirely cover the inner surface of the openings CHa and CHb.

The auxiliary pad PD-I may be electrically connected to a first pad PD1. The auxiliary pad PD-I may be electrically connected to the first pad PD1 through conductive members SOLa and SOLb. The auxiliary pad PD-I may be electrically connected to a second pad PD2.

When viewed from below a base layer 110, the auxiliary pad PD-I may cover (e.g., entirely cover) the conductive members SOLa and SOLb. For example, by expanding a contact area between the auxiliary pad PD-I and the conductive members SOLa and SOLb, reliability of electrical connection between the first pad PD1 and the second pad PD2 may be improved or ensured through the auxiliary pad PD-I and the conductive members SOLa and SOLb.

The auxiliary pad PD-I may be provided in plurality, and the number of auxiliary pads PD-I may correspond to the number of conductive members SOLa and SOLb or the number of openings CHa and CHb.

FIG. 7 is a schematic cross-sectional view of a thermosetting conductive film SF according to an embodiment. For example, FIG. 7 illustrates the thermosetting conductive film SF before being disposed on the base layer 110 (see FIG. 5A), pressed and thermally cured.

Referring to FIG. 7, the thermosetting conductive film SF may include a base film BF-SF, a thermosetting film HL-SF, a conductive member SOL, and a liner LNR. The thermosetting conductive film SF according to an embodiment may be disposed on the base layer 110 (see FIG. 5A) described above after the liner LNR is removed later. Then, the thermosetting film HL-SF may be thermally cured by being pressed and heated and protect the conductive members SOL (see FIG. 5A) and the openings CH (see FIG. 5A) from an external foreign substance.

The conductive members SOL may have a dome shape at the upper surface, as can be seen in figs. 5A to 6A and 6C.

The base film BF-SF may include a lower surface defined by a first direction DR1 and a second direction DR2 intersecting each other, and an upper surface opposed to the lower surface.

The base film BF-SF may include a material having high thermal conductivity. For example, the base film BF-SF may include silicon (Si), but embodiments are not limited thereto. For example, the base film BF-SF may include a silicon compound.

Like the thermosetting film HL-SF to be described later, the base film BF-SF may be coupled to the display panel DP (see FIG. 5A), and then protect the conductive member SOL and the opening CH (see FIG. 5A) from the external foreign substance.

The thermosetting film HL-SF may be disposed under the base film BF-SF. A surface of the thermosetting film HL-SF may be in contact with the lower surface of the base film BF-SF.

The thermosetting film HL-SF may include a resin. The resin included in the thermosetting film HL-SF may be an epoxy-based resin. For example, the thermosetting film HL-SF may include a curing agent and a catalyst, but a material included in the thermosetting film HL-SF is not limited to the material described above.

The thermosetting film HL-SF may be coupled to the display panel DP (see FIG. 5A) and then correspond to the thermosetting member CV (see FIG. 5A) described above. The thermosetting film HL-SF may protect the conductive member SOL and the opening CH (see FIG. 5A) from the external foreign substance before and after being cured.

The conductive member SOL may be dispersed in the thermosetting film HL-SF. The conductive member SOL may pass through the thermosetting film HL-SF in a cross-sectional view.

At least a portion of the conductive member SOL may protrude from the thermosetting film HL-SF. As illustrated in the drawing, a side of the conductive member SOL may be positioned below the thermosetting film HL-SF. Accordingly, as will be described later, the conductive member SOL may be readily accommodated (or filled) in the opening CH (see FIG. 5A). Thus, a capability of the conductive member SOL to be accommodated (or filled) in the opening CH (see FIG. 5A) may be improved.

A diameter of the conductive member SOL in the thermosetting conductive film SF may be in a range of about 30 µm to about 130 µm.

The conductive member SOL of the thermosetting conductive film SF may have a diameter of about 30 µm to about 130 µm, and in case that the thermosetting conductive film SF and the display module DM (see FIG. 5A) are coupled to each other, the conductive member SOL may be accommodated (or filled) inside the opening CH (see FIG. 5A). For example, the conductive member SOL may be filled (e.g., entirely filled) inside the opening CH (see FIG. 5A). Accordingly, the first pad PD1 (see FIG. 5A) and the second pad PD2 (see FIG. 5A) may be allowed to be electrically connected to each other through the conductive member SOL accommodated (or filled) in the opening CH (see FIG. 5A). Thus, reliability of electrical connection between the display module DM (see FIG. 5A) and the circuit board FCB (see FIG. 5A) may be improved or ensured.

In case that the conductive member SOL has a diameter of about 30 µm or less, although the conductive member SOL is accommodated (or filled) inside the opening CH (see FIG. 5A), it is difficult for the conductive member SOL to entirely cover the opening CH (see FIG. 5A) of an upper surface of the base layer 110 (see FIG. 5A) since a maximum diameter (e.g., a first diameter) of the opening CH (see FIG. 5A) may be in a range of about 30 µm or more. As a result, it may be difficult for the conductive member SOL and the first pad PD1 (see FIG. 5A) to be allowed to be electrically connected to each other, and it may be difficult for the first pad PD1 (see FIG. 5A) and the second pad PD2 (see FIG. 5A) to be allowed to be electrically connected to each other through the conductive member SOL.

In case that the conductive member SOL has a diameter of about 130 µm or more, the conductive member SOL may be accommodated (or filled) in not only an opening CH (see FIG. 5A) but also another opening CH (see FIG. 5A) adjacent to the opening CH (see FIG. 5A), and pads PD (see FIG. 5B) adjacent to each other may thus be electrically connected. As a result, reliability of signal transfer may be improved or ensured.

The conductive member SOL may include tin (Sn). The conductive member SOL may further include a material such as silver (Ag) or copper (Cu).

The liner LNR may be disposed under the thermosetting film HL-SF. The liner LNR may include a protective film PL-SF and an adhesive film ADL-SF.

The protective film PL-SF may be disposed below the thermosetting film HL-SF. The protective film PL-SF may cover the conductive member SOL. Also, the protective film PL-SF may cover a lower portion of the thermosetting film HL-SF. Before the thermosetting conductive film SF is coupled to the display panel DP (see FIG. 5A), the protective film PL-SF may protect the thermosetting film HL-SF and the conductive member SOL from the external foreign substance and external damage.

The adhesive film ADL-SF may be provided between the protective film PL-SF and the thermosetting film HL-SF. The adhesive film ADL-SF may be in contact with (e.g., in directly contact with) or coat (e.g., directly coat) the protective film PL-SF. The adhesive film ADL-SF may be attached to each of the thermosetting film HL-SF and the protective film PL-SF. In another example, the adhesive film may be attached to each of the conductive member SOL and the protective film PL-SF.

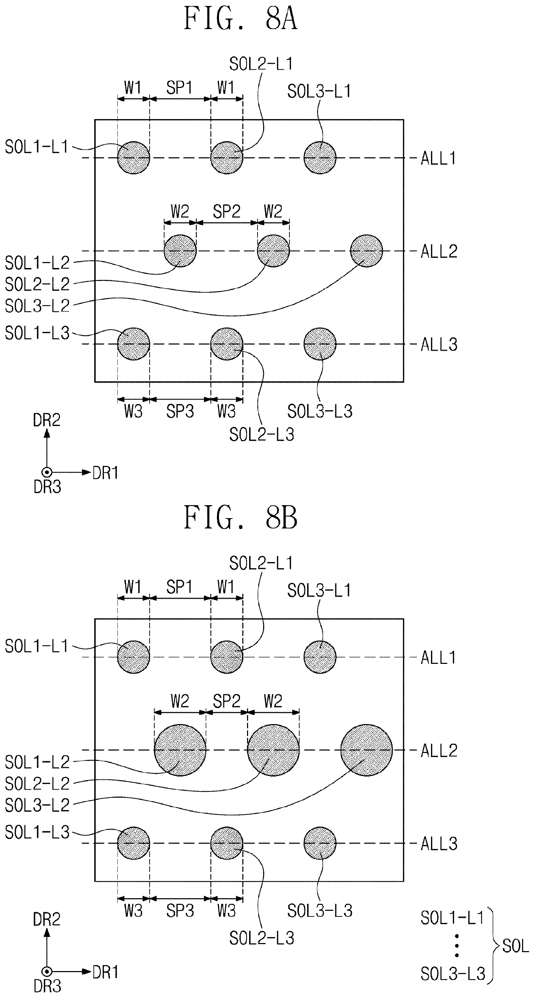

FIGS. 8A to 8C are schematic plan views of a thermosetting conductive film SF according to an embodiment.

Referring to FIG. 8A, conductive members SOL in the thermosetting conductive film SF (see FIG. 7) may include first-row conductive members SOL1-L1, SOL2-L1 andSOL3-L1, second-row conductive members SOL1-L2, SOL2-L2, and SOL3-L2, and third-row conductive members SOL1-L3, SOL2-L3, and SOL3-L3.

The first-row conductive members SOL1-L1, SOL2-L1, and SOL3-L1 and the second-row conductive members SOL1-L2, SOL2-L2, and SOL3-L2 may be spaced apart from each other in a second direction DR2. The second-row conductive members SOL1-L2, SOL2-L2, and SOL3-L2 and the third-row conductive members SOL1-L3, SOL2-L3, and SOL3-L3 may be spaced apart from each other in the second direction DR2.

The first-row conductive members SOL1-L1, SOL2-L1, and SOL3-L1 may be arranged in a first direction DR1 along a first alignment line ALL1. The second-row conductive members SOL1-L2, SOL2-L2, and SOL3-L2 may be arranged in the first direction DR1 along a second alignment line ALL2. The third-row conductive members SOL1-L3, SOL2-L3, and SOL3-L3 may be arranged in the first direction DR1 along a third alignment line ALL3.

The second-row conductive members SOL1-L2, SOL2-L2, and SOL3-L2 may be shifted in the first direction DR1 by a selected distance from the first-row conductive members SOL1-L1, SOL2-L1, and SOL3-L1. The third-row conductive members SOL1-L3, SOL2-L3, and SOL3-L3 may be arranged in the first direction DR1. The third-row conductive members SOL1-L3, SOL2-L3, and SOL3-L3 may be shifted in the first direction DR1 by a selected distance from the second-row conductive members SOL1-L2, SOL2-L2, and SOL3-L2. For example, the spacing SP1 in the first direction DR1 between the first-row conductive members SOL1-L1, SOL2-L1, and SOL3-L1 may be substantially equal to or greater than the widths W1 of the first-row conductive members SOL1-L1, SOL2-L1, and SOL3-L1. For example, the spacing SP2 in the first direction DR1 between the second-row conductive members SOL1-L2, SOL2-L2, and SOL3-L2 may be substantially equal to or greater than the widths W2 of the second-row conductive members SOL1-L2, SOL2-L2, and SOL3-L2. For example, the spacing SP3 in the first direction DR1 between the third-row conductive members SOL1-L3, SOL2-L3, and SOL3-L3 may be substantially equal to or greater than the widths W3 of the third-row conductive members SOL1-L3, SOL2-L3, and SOL3-L3.

An arrangement relationship of conductive members SOL in the thermosetting conductive film SF may correspond to an arrangement relationship of the openings CH (see FIG. 5A) of a display panel or an arrangement relationship of the first pads PD1 (see FIG. 5A). The drawing illustrates only the first to third-row conductive members SOL, but a display device may further include fourth-row conductive members.

Referring to FIG. 8B, sizes of the second-row conductive members SOL1-L2, SOL2-L2, and SOL3-L2 may be different from sizes of the first-row conductive members SOL1-L1, SOL2-L1, and SOL3-L1. As illustrated in the drawing, the sizes of the second-row conductive members SOL1-L2, SOL2-L2, and SOL3-L2 may be greater than the sizes of the first-row conductive members SOL1-L1, SOL2-L1, and SOL3-L1. For example, the spacing SP1 in the first direction DR1 between the first-row conductive members SOL1-L1, SOL2-L1, and SOL3-L1 may be substantially equal to or greater than the widths W1 of the first-row conductive members SOL1-L1, SOL2-L1, and SOL3-L1. For example, the spacing SP2 in the first direction DR1 between the second-row conductive members SOL1-L2, SOL2-L2, and SOL3-L2 may be substantially equal to or less than the widths W2 of the second-row conductive members SOL1-L2, SOL2-L2, and SOL3-L2. For example, the spacing SP3 in the first direction DR1 between the third-row conductive members SOL1-L3, SOL2-L3, and SOL3-L3 may be substantially equal to or greater than the widths W3 of the third-row conductive members SOL1-L3, SOL2-L3, and SOL3-L3.

Without being limited to what is illustrated in the drawing, the sizes of the first-row conductive members SOL1-L1, SOL2-L1, and SOL3-L1 may be greater than the sizes of the second-row conductive members SOL1-L2, SOL2-L2, and SOL3-L2, but embodiments are not limited thereto.

The drawing illustrates that the conductive members SOL in the same row have the same size, but embodiments are not limited thereto, and the conductive members SOL in the same row may have different sizes.

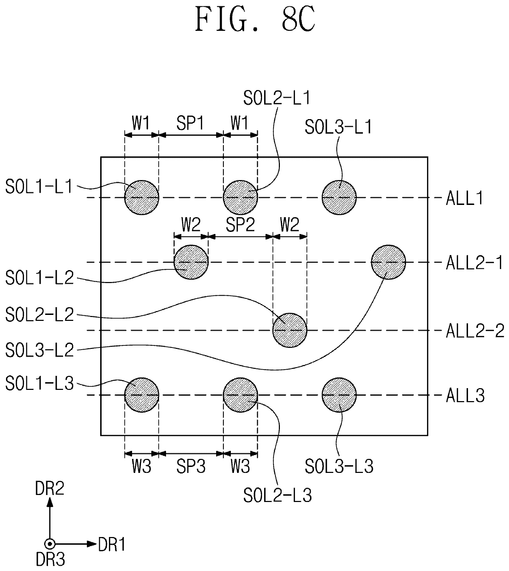

Referring to FIG. 8C, the spacing SP1 in the first direction DR1 between the first-row conductive members SOL1-L1, SOL2-L1, and SOL3-L1, the spacing SP2 in the first direction DR1 between the second-row conductive members SOL1-L2, SOL2-L2, and SOL3-L2, and the spacing SP3 in the first direction DR1 between the third-row conductive members SOL1-L3, SOL2-L3, and SOL3-L3 may be the same as each other.

A second alignment line ALL2 may include a (2-1)-th alignment line ALL2-1 and a (2-2)-th alignment line ALL2-2. The (2-1)-th alignment line ALL2-1 and the (2-2)-th alignment line ALL2-2 may be spaced apart from each other in a second direction DR2.

Some of the second-row conductive members SOL2-L2 may be arranged along the (2-1)-th alignment line ALL2-1, and the rest of the second-row conductive members SOL2-L2 may be arranged along the (2-2)-th alignment line ALL2-2.

From the second-row conductive members SOL1-L2, SOL2-L2, and SOL3-L2 arranged along the (2-1)-th alignment line ALL2-1, the second-row conductive members SOL1-L2, SOL2-L2, and SOL3-L2 arranged along the (2-2)-th alignment line ALL2-2 may be shifted in the first direction DR1 by a selected distance.

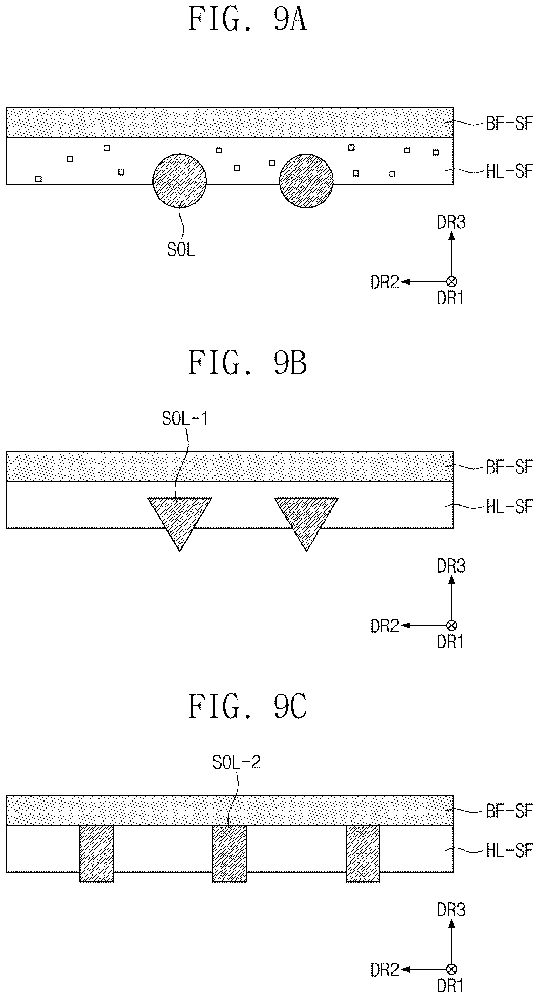

FIGS. 9A to 9C are schematic cross-sectional views of a thermosetting conductive film SF according to an embodiment.

Referring to FIG. 9A, a thermosetting film HL-SF may further include a filler. The filler may further increase thermal conductivity of the thermosetting film HL-SF in a process of heating the thermosetting film HL-SF to be described later.

A conductive member SOL may be spaced apart from a base film BF-SF. The conductive member SOL may have an initial form of a sphere. The conductive member SOL in a thermosetting conductive film SF may have various forms without being limited to what is illustrated in the drawing, but embodiments are not limited thereto.

Referring to FIG. 9B, a width of a conductive member SOL-1 in a second direction DR2 may decrease as being farther away from a thermosetting film HL-SF. Thus, the conductive member SOL-1 may be readily accommodated (or filled) in an opening CH (see FIG. 5A) in a process of coupling a thermosetting conductive film SF and a display panel DP (see FIG. 5A) to each other to be described later.

The drawing illustrates that the width of the conductive member SOL-1 decreases in the second direction DR2, but the width of the conductive member SOL-1 may also decrease in the first direction DR1, but embodiments are not limited thereto.

Referring to FIG. 9C, the width of a conductive member SOL-2 may be constant in a second direction DR2. The drawing illustrates that the width of the conductive member SOL-2 in the second direction DR2 is substantially constant, but the width of the conductive member SOL-2 in the first direction DR1 may also be constant, but embodiments are not limited thereto.

For example, the conductive member SOL-2 may pass through a thermosetting film HL-SF and may be in contact with a base film BF-SF.

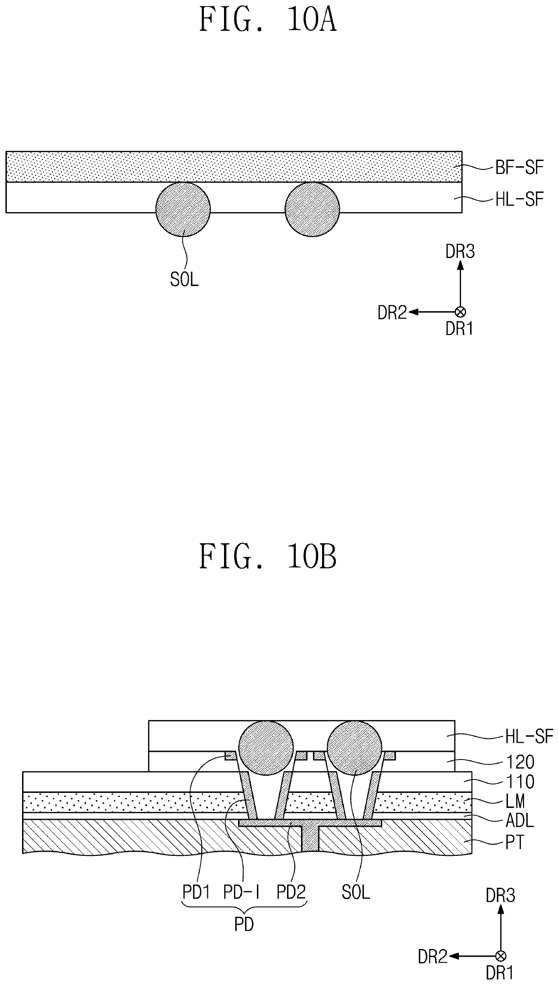

FIGS. 10A to 10D are schematic cross-sectional views illustrating some of operations of coupling a thermosetting conductive film SF to a display panel DP according to an embodiment. The same/similar components as/to the components described with reference to FIGS. 1 to 9C are denoted as the same/similar reference numerals or symbols, and repeated description is omitted.

A method of manufacturing a display device according to an embodiment may include preparing a display panel DP (see FIG. 5A) and a thermosetting conductive film SF (see FIG. 7) and coupling the display panel DP (see FIG. 5A) and the thermosetting conductive film SF (see FIG. 7) to each other.

The coupling of the display panel DP (see FIG. 5A) and the thermosetting conductive film SF (see FIG. 7) to each other may include removing a protective film PL-SF (see FIG. 7) of the thermosetting conductive film SF (see FIG. 7), aligning an opening CH of the display panel DP (see FIG. 5A) and a conductive member SOL of the thermosetting conductive film SF (see FIG. 7), inserting the conductive member SOL of the thermosetting conductive film SF (see FIG. 7) into the opening CH of the display panel DP (see FIG. 5A), disposing a thermosetting film HL-SF of the thermosetting conductive film SF on a base layer 110, disposing a thermal conductive member HPL on the thermosetting conductive film SF (see FIG. 7), disposing a thermal compression device PRU on the thermal conductive member HPL and applying pressure and heat to the thermosetting conductive film SF (see FIG. 7), and removing the thermal conductive member HPL and the thermal compression device PRU.

Referring to FIG. 10A, in removing the protective film PL-SF (see FIG. 7) of the thermosetting conductive film SF (see FIG. 7), an adhesive film ADL-SF (see FIG. 7) may be removed along with the protective film PL-SF (see FIG. 7). As illustrated in the drawing, a base film BF-SF may remain, but the base film BF-SF may be removed along with the protective film PL-SF (see FIG. 7) and embodiments are not limited thereto.

Referring to FIG. 10B, after aligning an opening CH of a display panel DP according to an embodiment of the invention (see FIG. 5A) and a conductive member SOL of the thermosetting conductive film SF according to an embodiment of the invention (see FIG. 7), the conductive member SOL of the thermosetting conductive film SF (see FIG. 7) may be inserted into the opening CH of the display panel DP (see FIG. 5A). Conductive members SOL may be inserted into and accommodated (or filled) in openings CH at the same time. The conductive members SOL may not need to be individually inserted into and accommodated (or filled) in the openings CH, thereby reducing process cost and process time. For example, the lower member LM may be attached to the supporting plate PT by the adhesive layer ADL.

All embodiments may have an advantage thousands of solder holes may be soldered simultaneously. Further, soldering may be possible with heat and pressure, therefore a soldering process may be possible in holes with a small size, in particular tens to several microns. Because pressure is applied, smooth soldering may be possible even in holes with a deep depth to width ratio.

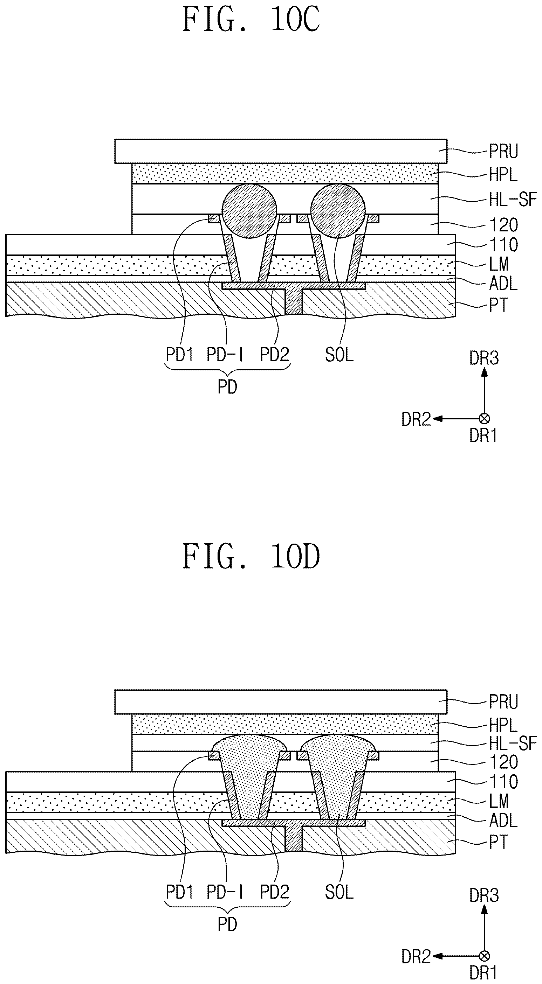

Referring to FIGS. 10C and 10D, after disposing a thermal conductive member HPL on the thermosetting conductive film SF (see FIG. 7) and disposing a thermal compression device PRU on the thermal conductive member HPL, pressure and heat may be applied to a thermosetting film HL-SF and the conductive member SOL.

The thermal conductive member HPL may include a material having high thermal conductivity so as to readily transfer pressure and heat to the thermosetting film HL-SF and the conductive member SOL.

Heat may be applied to the conductive member SOL, and a form of the conductive member SOL may thus change. Here, the conductive member SOL may be accommodated (or filled) in the opening CH and cover (e.g., entirely cover) the opening CH. Thus, pads PD (e.g., the first pad PD1 and the second pad PD2) may be electrically connected thereto. Reliability of electrical connection between the display panel DP (see FIG. 5A) and a circuit board FCB (see FIG. 5A) may be improved or ensured.

Heat and pressure may be applied to the thermosetting film HL-SF, and the thermosetting film HL-SF may thus be cured. A cured thermosetting film HL-SF may protect the conductive member SOL and the opening CH from an external foreign substance.

Then, the thermal conductive member HPL and the thermal compression device PRU may be removed, and a display device DD according to an embodiment may be completed.

A display device DD according to an embodiment may have a reduced area of a pad region PA of a display panel DP, thereby having a reduced area of an entire non-display region of the display panel DP.

A display device DD according to an embodiment may have some pads positioned on a lower portion of a display panel DP, thereby having a reduced area of a pad region PA on an upper portion of the display panel DP.

A display device DD according to an embodiment may electrically connect pads PD disposed on upper and lower portions of a display panel DP through a conductive member SOL that is accommodated (or filled) in an opening CH of the display panel DP.

A display device DD according to an embodiment may improve or ensure reliability of electrical connection between a display panel DP and a circuit board FCB through a conductive member SOL that is positioned up to a lower portion of an opening CH of the display panel DP.

A display device DD according to an embodiment may prevent an external substance from being introduced (or permeated) between a conductive member SOL and an opening CH through a thermosetting member CV disposed on a conductive member SOL, thereby ensuring reliability of electrical connection between a display panel DP and a circuit board FCB.

A display device DD according to an embodiment may improve or ensure reliability of electrical connection between pads PD of a display panel DP through openings CH and a thermosetting member CV which fixes conductive members SOL.

A display device DD according to an embodiment may, through a thermosetting conductive film SF which fixes aligned conductive members SOL, match the conductive members SOL to openings CH at once, thereby reducing process time and cost.

In concluding the detailed description, those skilled in the art will appreciate that many variations and modifications may be made to the embodiments without substantially departing from the principles and scope of the invention. Therefore, the disclosed embodiments are used in a generic and descriptive sense only and not for purposes of limitation.

## Claims

1. A display device (DD) comprising:
a display panel (DP) including:
a base layer (110),
a driving element layer (120) disposed on the base layer (110) and including circuits,
a light-emitting element layer (130) disposed on the driving element layer (120) and including a plurality of light-emitting elements respectively electrically connected to the circuits of the driving element layer (120),
a plurality of pads (PD1, PD2, PD3) disposed on the base layer (110), and
a plurality of openings (CH) passing through the base layer (110), the driving element layer (120), and the plurality of pads (PD1, PD2, PD3);
a circuit board (FCB) disposed below the display panel (DP);
a plurality of conductive members (SOL) disposed on the base layer (110) and overlapping the plurality of pads (PD1, PD2, PD3); and
a thermosetting member (CV) covering the plurality of conductive members (SOL),
wherein the plurality of conductive members (SOL) are respectively disposed in the plurality of openings (CH) and electrically connect the driving element layer (120) and the circuit board (FCB).

2. The display device (DD) of claim 1, wherein the plurality of conductive members (SOL) comprise:
a plurality of first-row conductive members (SOL1-L1, SOL2-L1) arranged in a first direction (DR1), and
a plurality of second-row conductive members (SOL1-L2, SOL2-L2) spaced apart from the first-row conductive members (SOL1-L1, SOL2-L1) in a second direction (DR2) intersecting the first direction (DR1) and arranged in the first direction (DR1).

3. The display device (DD) of claim 2, wherein when viewed in the second direction (DR2), the plurality of second-row conductive members (SOL1-L2, SOL2-L2) do not overlap the plurality of first-row conductive members (SOL1-L1, SOL2-L1).

4. The display device (DD) of claim 2 or 3, wherein in plan view, sizes of the first-row conductive members (SOL1-L1, SOL2-L1) and sizes of the second-row conductive members (SOL1-L2, SOL2-L2) are different from each other.

5. The display device (DD) of at least one of claims 2 to 4, wherein
the plurality of second-row conductive members (SOL1-L2, SOL2-L2) comprise a plurality of first conductive members and a plurality of second conductive members being aligned along the first direction (DR1), and
the plurality of second conductive members are disposed to be shifted in the second direction (DR2) by a selected distance from the first conductive members.

6. The display device (DD) of at least one of claims 1 to 5, wherein a cross-sectional area of each of the plurality of openings (CH) decreases as being farther away from an upper surface of the base layer (110).

7. The display device (DD) of at least one of claims 1 to 6, wherein in plan view, a width of each of the plurality of openings (CH) is in a range of about 20 µm to about 40 µm.

8. The display device (DD) of at least one of claims 1 to 7, wherein a maximum width of the plurality of conductive members (SOL) is substantially equal to or greater than a maximum width of the plurality of openings (CH).

9. The display device (DD) of at least one of claims 1 to 8, wherein sizes of upper surfaces of the plurality of conductive members (SOL) is substantially equal to or smaller than sizes of the plurality of pads (PD1, PD2, PD3).

10. The display device (DD) of at least one of claims 1 to 9, wherein when viewed from above the base layer (110), the plurality of conductive members (SOL) are entirely covered by the thermosetting member (CV).

11. The display device (DD) of at least one of claims 1 to 10, wherein the display panel (DP) further comprises an auxiliary pad (PD-I) disposed on an inner surface of at least one of the plurality of openings (CH).

12. The display device (DD) of claim 11, wherein when viewed from below the base layer (110), the plurality of conductive members (SOL) are entirely covered by the auxiliary pad (PD-I).

13. The display device (DD) of at least one of claims 1 to 12, wherein the plurality of conductive members (SOL) comprise tin, silver, or copper.

14. A thermosetting conductive film (SF) comprising:
a base film (BF-SF) including a lower surface defined by a first direction (DR1) and a second direction (DR2) intersecting each other and an upper surface opposed to the lower surface;
a thermosetting film (HL-SF) disposed on the lower surface of the base film; and
a plurality of conductive members (SOL) dispersed in the thermosetting film (HL-SF), passing through the thermosetting film (HL-SF) in a cross-sectional view, and including tin.

15. The thermosetting conductive film (SF) of claim 14, wherein
the plurality of conductive members (SOL) are arranged in the first direction (DR1), and
a spacing (SP1, SP2) between the plurality of conductive members (SOL) adjacent to each other is substantially equal to or greater than a width in the first direction (DR1) of each of the plurality of conductive members (SOL).

16. The thermosetting conductive film (SF) of claim 14 or 15, wherein the base film (BF-SF) comprises silicon.

17. The thermosetting conductive film (SF) of at least one of claims 14 to 16, further comprising:
a protective film (PL-SF) disposed below the thermosetting film (HL-SF) and covering the plurality of conductive members (SOL); and
an adhesive film (ADL-SF) disposed between the thermosetting film (HL-SF) and the protective film (PL-SF).

18. The thermosetting conductive film (SF) of at least one of claims 14 to 17, wherein diameters of the plurality of conductive members (SOL) are in a range of about 30 µm to about 130 µm.

19. The thermosetting conductive film (SF) of at least one of claims 14 to 18, wherein the plurality of conductive members (SOL) have an initial form of a sphere.

20. The thermosetting conductive film (SF) of at least one of claims 14 to 19, wherein widths of the plurality of conductive members (SOL) in the first direction (DR1) or the second direction (DR2) decrease as being farther away from the thermosetting film (HL-SF).
